(19) 

**Europäisches Patentamt**
**European Patent Office**
**Office européen des brevets**

(11) **EP 4 465 416 A1**

(12) **EUROPEAN PATENT APPLICATION**
published in accordance with Art. 153(4) EPC

(43) Date of publication:
20.11.2024 Bulletin 2024/47

(21) Application number: 22939235.2

(22) Date of filing: 29.04.2022

(51) International Patent Classification (IPC):
*H01M 10/615* (2014.01)

(52) Cooperative Patent Classification (CPC):
H01M 10/615

(86) International application number:
PCT/CN2022/090368

(87) International publication number:
WO 2023/206386 (02.11.2023 Gazette 2023/44)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: **Contemporary Amperex Technology
(Hong Kong) Limited
Central, Central And Western District (HK)**

(72) Inventors:
• **CHEN, Xinwei
Ningde, Fujian 352100 (CN)**

• **YAN, Yu
Ningde, Fujian 352100 (CN)**
• **DAN, Zhimin
Ningde, Fujian 352100 (CN)**
• **LI, Zhanliang
Ningde, Fujian 352100 (CN)**
• **ZHAO, Yuanmiao
Ningde, Fujian 352100 (CN)**

(74) Representative: **Holt, Lucy Rose et al
Maucher Jenkins
Seventh Floor Offices
Artillery House
11-19 Artillery Row
London SW1P 1RT (GB)**

(54) **HEATING METHOD, HEATING APPARATUS AND HEATING SYSTEM FOR BATTERY**

(57) Provided in the present application are a heating method, heating apparatus and heating system for a battery, wherein same can effectively heat a power battery with a relatively high heating efficiency. The heating method is applied to a heating circuit, the heating circuit is connected to a battery to output a heating current to the battery, and the heating current is used for heating the battery. The heating method comprises: acquiring polarization parameters of a battery; determining the frequency of a heating current according to the polarization parameters and a peak current of a heating circuit, such that the amplitude of the heating current does not exceed the peak current; and controlling the heating circuit to output a heating current with the frequency to the battery.

FIG. 3

EP 4 465 416 A1

**Description**

**TECHNICAL FIELD**

The present application relates to the technical field of batteries, in particular to a battery heating method, heating apparatus, and heating system.

**BACKGROUND**

Due to the advantages such as high energy density, being rechargeable cyclically and being safe and environmentally friendly, power batteries are widely used in fields such as new energy automobiles, consumer electronics, and energy storage systems.

However, the use of power batteries in a low-temperature environment may be limited to some extent, for example, the discharge capacity of the power batteries in a low-temperature environment may greatly decline, and the power batteries cannot be charged in a low-temperature environment. In order to normally use the power batteries, the power batteries need to be heated in a low-temperature environment. How to effectively heat the power batteries becomes a problem needing to be solved urgently.

**SUMMARY**

The present application provides a battery heating method, heating apparatus, and heating system, which can effectively heat a power battery, thereby achieving a high heating efficiency.

A first aspect provides a battery heating method, applied to a heating circuit, the heating circuit is connected to a battery and is configured to output a heating current to the battery, and the heating current is configured to heat the battery, the heating method including: acquiring polarization parameters of a battery; determining a frequency of the heating current according to the polarization parameters and a peak current of the heating circuit, so that the amplitude value of the heating current does not exceed the peak current; and controlling the heating circuit to output the heating current having the frequency to the battery.

In the embodiments of the present application, the heating circuit outputs an alternating-current heating current to the battery, so as to heat the battery. The frequency of the heating current is related to the heating efficiency, so it is necessary to determine an optimal frequency of the heating current. During determination of the optimal frequency of the heating current, the peak current of the heating circuit is taken as a condition, so as to prevent the amplitude value of the heating current from exceeding the peak current of the heating circuit, thereby avoiding damage to other components in the heating circuit in the heating process.

In one implementation, determining a frequency of the heating current according to the polarization parameters and a peak current of the heating circuit, so that an amplitude value of the heating current does not exceed the peak current includes: determining the frequency of the heating current according to the polarization parameters, the peak current, and an equilibrium potential of a lithium plating reaction of the battery, so that the amplitude value of the heating current does not exceed the peak current and a polarization voltage of the battery does not exceed the equilibrium potential.

In this embodiment, taking the peak current of the heating circuit and the equilibrium potential of the lithium plating reaction as a condition during the determination of the optimal frequency of the heating current can not only prevent the amplitude value of the heating current from exceeding the peak current of the heating circuit, but also avoid damage to other components in the heating circuit, and can avoid a lithium plating phenomenon caused by the fact that the polarization voltage of the battery exceeds the equilibrium potential of the lithium plating reaction, thereby ensuring the safety of the battery.

The polarization parameters include, for example, a polarization internal resistance and a polarization capacitance of the battery.

In one implementation, determining the frequency of the heating current according to the polarization parameters, the peak current, and an equilibrium potential of a lithium plating reaction of the battery includes: determining, according to the polarization internal resistance, the polarization capacitance, the peak current and the equilibrium potential, the angular frequency of the heating current; and determining the frequency of the heating current according to the angular frequency of the heating current.

As the battery is heated by using an alternating current, in this embodiment, the angular frequency of the alternating current can be determined according to the polarization internal resistance and polarization capacitance of the battery, and the peak current of the heating circuit and the equilibrium potential of the lithium plating reaction, and then the frequency of the alternating current is determined according to the angular frequency; and the calculation is simple and easy to implement.

In one implementation, determining an angular frequency of the heating current according to the polarization internal resistance, the polarization capacitance, the peak current, and the equilibrium potential includes: according to the polarization internal resistance, the polarization capacitance, the peak current and the equilibrium potential, determining the angular frequency of the heating current based on the following formula: $[R1/(1+j\omega R1C1)]\times I_A=X\times U_{e,1}$, where R1 is the polarization internal resistance, C1 is the polarization capacitance, $I_A$ is the peak current, $U_{e,1}$ is the corresponding equilibrium potential of the battery in the current state of charge (SOC), $\omega$ is the angular frequency of the heating current, X is a preset value, and X is greater than 0 and less than or equal to 1.

In this embodiment, when the polarization internal resistance R1 and the polarization capacitance C1 of the battery are acquired in advance, according to the formula $[R1/(1+j\omega R1C1)]\times I_A=X\times U_{e,1}$, the optimal angular frequency $\omega$ of the heating current can be obtained, and the optimal frequency of the heating current can be further obtained. The polarization voltage $Ux=[R1/(1+j\omega R1C1)]\times I$, setting the parameter X less than or equal to 1, and enabling that $Ux=X\times U_{e,1}$ can make the polarization voltage Ux not exceed the equilibrium potential $U_{e,1}$, thereby avoiding a lithium plating phenomenon caused by the fact that the polarization voltage of the battery exceeds the equilibrium potential $U_{e,1}$ of the lithium plating reaction. Furthermore, defining the current I in $Ux=[R1/(1+j\omega R1C1)]\times I$ to be equal to the peak current $I_A$ of the heating circuit prevents the amplitude value of the heating current from exceeding the peak current $I_A$ of the heating circuit, thereby avoiding damage to other components in the heating circuit in the heating process.

In one implementation, determining the frequency of the heating current according to the angular frequency includes: determining the frequency of the heating current according to $\omega=2\pi f$, where $\omega$ is the angular frequency of the heating current and f is the frequency of the heating current.

In one implementation, acquiring the polarization parameters of the battery includes: determining, according to an equivalent circuit of the battery, an equation representing a relationship among an open circuit voltage, a terminal voltage, and a current of the battery, the equation being associated with the polarization internal resistance and the polarization capacitance; performing sampling on the open circuit voltage, the terminal voltage and the current in the heating process for multiple times, so as to obtain a plurality of sets of sampling data; and according to the plurality of sets of sampling data, determining the polarization internal resistance and the polarization capacitance based on the equation.

In this embodiment, by establishing the equivalent circuit of the battery, the equation representing the relationship among the open circuit voltage, the terminal voltage, and the current of the battery is obtained, and the equation is associated with the polarization internal resistance and the polarization capacitance of the battery. In this way, by sampling the open circuit voltage, the terminal voltage and the current of the battery in the heating process for multiple times in advance, the plurality of sets of sampling data can be obtained, and by substituting the plurality of sets of sampling data into the equation, the polarization internal resistance and the polarization capacitance of the battery can be obtained; and the calculation is simple and easy to implement. In this way, in cases where the polarization internal resistance and the polarization capacitance of the battery are obtained in advance, the angular frequency of the heating current can be obtained according to the described formula, and the frequency of the heating current may be further obtained.

In one implementation, the equivalent circuit is a first-order Thevenin equivalent circuit, and the equation is: $U0=[R1/(1+j\omega R1C1)]\times I_A+I\times R0+U$, where $U_0$ is the corresponding open circuit voltage of the battery at the current SOC and temperature, U is the terminal voltage, I is the current, R1 is the polarization internal resistance, C1 is the polarization capacitance, and R0 is an ohmic internal resistance of the battery.

In this embodiment, the polarization internal resistance and the polarization capacitance of the battery are determined by establishing a first-order Thevenin equivalent circuit and a corresponding model formula thereof, and the model is simple and easy to implement. Certainly, in the embodiments of the present application, another circuit model may also be used to determine the polarization internal resistance and the polarization capacitance of the battery.

In one implementation, determining the polarization internal resistance and the polarization capacitance according to the plurality of sets of sampling data based on the equation includes: converting the equation to a polynomial in a differential form: $U_0(k)-U(k)=k1\times[U_0(k-1)-U(k-1)]+k2\times I(k)-k3\times I(k-1)$, where $k1=R1C1/(T+R1C1)$, $k2=[R0R1C1+T(R0+R1)]/(T+R1C1)$, $k3=R0R1C1/(T+R1C1)$, $U_0(k)$ and $U_0(k-1)$ are the sampling data of the open circuit voltage obtained by performing kth sampling and performing (k-1)th sampling respectively, U(k) and U(k-1) are the sampling data of the terminal voltage obtained by performing the kth sampling and performing the (k-1)th sampling respectively, I(k) and I(k-1) are the sampling data of the current obtained by performing the kth sampling and performing the (k-1)th sampling respectively, T is a sampling time interval, and k is a positive integer greater than 1; according to the plurality of sets of sampling data, determining k1, k2 and k3 based on the polynomial; and according to k1, k2 and k3, determining that the polarization internal resistance and the polarization voltage are $R1=(k2-k3)/(1-k1)-k3/k1$ and $C1=(k1\times k1\times T)/[k1\times(k2-k3)-k3\times(1-k1)]$ respectively.

In this embodiment, by converting the equation corresponding to the equivalent circuit of the battery into a polynomial in a differential form, an imaginary part in the equation can be effectively removed, thereby facilitating the determination of the polarization internal resistance and the polarization capacitance of the battery by using the sampling data of the open circuit voltage, the terminal voltage, and the current.

In one implementation, the heating current is an alternating current, and the waveform of the alternating current is any one of a pulse wave, a square wave, a triangular wave, and a sine wave.

In one implementation, the heating circuit includes a power supply, and the power supply is connected to the battery.

In one implementation, the heating circuit includes an energy storage unit and a voltage conversion module, and the voltage conversion module is connected between the energy storage unit and the battery.

A second aspect provides a battery heating apparatus, applied to a heating circuit, where the heating circuit is connected to a battery and is configured to output a heating current to the battery, and the heating current is configured to heat the battery, the heating apparatus including: a processing module, configured to acquire polarization parameters of a battery, and determine a frequency of the heating current according to the polarization parameters and a peak current of the heating circuit, so that the amplitude value of the heating current does not exceed the peak current; and a control module, configured to control the heating circuit to output the heating current having the frequency to the battery.

In one implementation, the processing module is specifically configured to: determine the frequency of the heating current according to the polarization parameters, the peak current, and an equilibrium potential of a lithium plating reaction of the battery, so that the amplitude value of the heating current does not exceed the peak current and a polarization voltage of the battery does not exceed the equilibrium potential.

In one implementation, the polarization parameters include the polarization internal resistance and the polarization capacitance of the battery.

In one implementation, the processing module is specifically configured to: determine the angular frequency of the heating current according to the polarization internal resistance, the polarization capacitance, the peak current and the equilibrium potential; and determine the frequency of the heating current according to the angular frequency of the heating current.

In one implementation, the processing module is specifically configured to: determine, according to the polarization internal resistance, the polarization capacitance, the peak current and the equilibrium potential, the angular frequency of the heating current based on the following formula: $[R1/(1+j\omega R1C1)] \times I_A = X \times U_{e,1}$, where R1 is the polarization internal resistance, C1 is the polarization capacitance, $I_A$ is the peak current, $U_{e,1}$ is the corresponding equilibrium potential of the battery in the current state of charge (SOC), $\omega$ is the angular frequency of the heating current, X is a preset value, and X is greater than 0 and less than or equal to 1.

In one implementation, the processing module is specifically configured to: determine the frequency of the heating current according to $\omega=2\pi f$, where $\omega$ is the angular frequency of the heating current and $f$ is the frequency of the heating current.

In one implementation, the processing module is specifically configured to: determine, according to the equivalent circuit of the battery, an equation representing a relationship among the open circuit voltage, the terminal voltage, and the current of the battery, the equation being associated with the polarization internal resistance and the polarization capacitance; perform sampling on the open circuit voltage, the terminal voltage and the current in the heating process for multiple times, so as to obtain a plurality of sets of sampling data; and according to the plurality of sets of sampling data, determine the polarization internal resistance and the polarization capacitance based on the equation.

In one implementation, the equivalent circuit is a first-order Thevenin equivalent circuit, and the equation is: $U0=[R1/(1+j\omega R1C1)] \times I_A + I \times R0 + U$, where $U_0$ is the corresponding open circuit voltage of the battery at the current SOC and temperature, U is the terminal voltage, I is the current, R1 is the polarization internal resistance, C1 is the polarization capacitance, and R0 is an ohmic internal resistance of the battery.

In one implementation, the processing module is specifically configured to: convert the equation to a polynomial in a differential form: $U_0(k)-U(k)=k1 \times [U_0(k-1)-U(k-1)]+k2 \times I(k)-k3 \times I(k-1)$, where $k1=R1C1/(T+R1C1)$, $k2=[R0R1C1+T(R0+R1)]/(T+R1C1)$, $k3=R0R1C1/(T+R1C1)$, $U_0(k)$ and $U_0(k-1)$ are the sampling data of the open circuit voltage obtained by performing kth sampling and performing (k-1)th sampling respectively, U(k) and U(k-1) are the sampling data of the terminal voltage obtained by performing the kth sampling and performing the (k-1)th sampling respectively, I(k) and I(k-1) are the sampling data of the current obtained by performing the kth sampling and performing the (k-1)th sampling respectively, T is a sampling time interval, and k is a positive integer greater than 1; according to the plurality of sets of sampling data, determine k1, k2 and k3 based on the polynomial; and according to k1, k2 and k3, determine that the polarization internal resistance and the polarization voltage are $R1=(k2-k3)/(1-k1)-k3/k1$ and $C1=(k1 \times k1 \times T)/[k1 \times (k2-k3)-k3 \times (1-k1)]$ respectively.

In one implementation, the heating current is an alternating current, and the waveform of the alternating current is any one of a pulse wave, a square wave, a triangular wave, and a sine wave.

In one implementation, the heating circuit includes a power supply, and the power supply is connected to the battery.

In one implementation, the heating circuit includes an energy storage unit and a voltage conversion module, and the voltage conversion module is connected between the energy storage unit and the battery.

In one implementation, the heating apparatus is a control circuit of the heating circuit, or the heating apparatus is a Battery Management System (BMS) of the battery.

A third aspect provides a battery heating apparatus including a memory and a processor, where the memory stores computer instructions, and the processor invokes the computer instructions to cause the heating apparatus to implement the battery heating method according to the first aspect or any implementation of the first aspect.

A fourth aspect provides a computer-readable storage medium, configured to store a computer program which causes, when the computer program is executed by a computing device, the computing device to implement the battery heating method according to the first aspect or any implementation of the first aspect.

A fifth aspect provides a battery heating system including: a battery; a heating circuit connected to the battery; and a battery heating apparatus according to the second aspect or any implementation of the second aspect, where the heating apparatus is connected to the heating circuit, the heating apparatus is configured to control the heating circuit to output a heating current, and the heating current is used for heating the battery.

## BRIEF DESCRIPTION OF THE DRAWINGS

To describe the technical solutions in the embodiments of the present application more clearly, the following accompanying drawings required for describing the embodiments of the present application are briefly illustrated. Apparently, the accompanying drawings in the following description show merely some embodiments of the present application, and those of ordinary skill in the art may still derive other drawings from the accompanying drawings without involving any inventive effort.

FIG. 1 is a schematic diagram of a heating system according to one embodiment of the present application.

FIG. 2 is a schematic diagram of a heating system according to another embodiment of the present application.

FIG. 3 is a schematic flow diagram of a battery heating method according to the embodiments of the present application.

FIG. 4 is an equivalent circuit of a battery according to the embodiments of the present application.

FIG. 5 is an equivalent circuit of another battery according to the embodiments of the present application.

FIG. 6 is a schematic diagram showing the relationship between the maximum allowable amplitude value of the heating current and the temperature and the frequency under the condition of suppressing lithium plating.

FIG. 7 is a schematic diagram showing the relationship between the heating power and the temperature and the current frequency under the condition of suppressing lithium plating.

FIG. 8 is a schematic diagram showing the most preferred choice of the frequency of the heating current under a given amplitude value of the heating current.

FIG. 9 is a first-order Thevenin equivalent circuit of the battery according to the embodiments of the present application.

FIG. 10 is a flow diagram of a possible specific implementation of the heating method shown in FIG. 3.

FIG. 11 is a schematic block diagram of a heating apparatus according to the embodiments of the present application.

## DESCRIPTION OF THE EMBODIMENTS

The implementations of the present application are further described in detail with reference to the accompanying drawings and embodiments. The following detailed description of the embodiments and the accompanying drawings are used to exemplarily explain the principle of the present application, but shall not be used to limit the scope of the present application, i.e. the present application is not limited to the described embodiments.

In the description of the present application, it should be noted that unless stated otherwise, "a plurality of" refers to two or more; the orientation or position relationship indicated by the terms "upper", "lower", "left", "right", "inner", "outer", etc. is only used to conveniently describe the present application and simplify the description, rather than indicating or implying that the indicated apparatus or element must have a specific orientation, be constructed and operated in a specific orientation, and therefore those terms cannot be understood as a limitation to the present application. In addition, the terms "first", "second", "third". etc. are used for the purpose of description only and cannot be understood as indicating or implying relative importance. The term "vertical" does not refer to being vertical in the strict sense, but is within the allowable range of error. The term "parallel" does not refer to being parallel in the strict sense, but is within the allowable range of error.

The orientation terms in the following description are all directions shown in the drawings, and do not limit the specific structure of the present application. In the description of the present application, it should also be noted that, unless specified or limited otherwise, the terms "mount", "connected to", and "connect" should be understood broadly, which may be, for example, fixed connections, detachable connections, or integral connections, and may also be direct connections or indirect connections via intermediate structures. The specific meanings of the above terms in the present application can be understood by those skilled in the art according to specific situations.

With the development of era, new energy vehicles have a great market prospect and can effectively promote energy conservation and emission reduction due to its advantages such as environmental protection, low noise, and low cost of use, and are beneficial to the development and improvement of the society.

Due to the electrochemical characteristics of power batteries, in a low-temperature environment, the charge and discharge capabilities of the power batteries are greatly limited, which greatly affects vehicle use experience of customers in winter. Therefore, in order to normally use the power batteries, the power batteries need to be heated in a low-temperature environment.

The power battery in the embodiments of the present application may be a lithium ion battery, a lithium metal battery, a lead acid battery, a nickel barrier battery, a nickel hydride battery, a lithium sulfur battery, a lithium air battery, a sodium ion battery, or the like, which is not limited herein. On the scale, the power battery in the embodiments of the present application may be a single cell, and may also be a battery module or a battery pack, which is not limited herein. As to the application scenario, the power battery may be applied to power devices such as automobiles and ships. For example, the power battery can be applied to power vehicles so as to supply power to electric motors of the power vehicles as a power source of the electric vehicles. The power battery may also supply power to other power consumption devices in the electric vehicles, such as vehicle-mounted air conditioners and on-board players. For ease of description, the solutions of the present application are illustrated below by taking an example of applying the power battery to a new energy vehicle (i.e. a power vehicle, or referred to as an electric vehicle).

When the battery is self-heated, an alternating current or a direct current may be used, where alternating-current heating is easy to be implemented, the heating speed is fast, the heating uniformity is good, the State of Charge (SOC) of the battery does not change, and the battery has no energy loss; although direct-current heating is low in cost and does not require other circuit elements, direct-current heating causes a large energy loss; and therefore, in the embodiments of the present application, an alternating current is used to heat the battery.

As the frequency of a heating current is related to the heating efficiency, the lower the frequency of the heating current is, the higher the heating efficiency is; however, an excessively low frequency easily causes a lithium plating reaction of a battery, and the process of a half-wave period is close to the process of direct current charging and discharging when the frequency is excessively low, such that the advantages of alternating-current heating cannot be embodied. Therefore, when the battery is heated by using an alternating current, it is necessary to determine and adjust an optimal frequency of a heating current.

On this basis, the embodiments of the present application provide a battery heating solution, which can effectively heat a battery, achieving a high heating efficiency, and not causing an influence on other elements in a heating circuit.

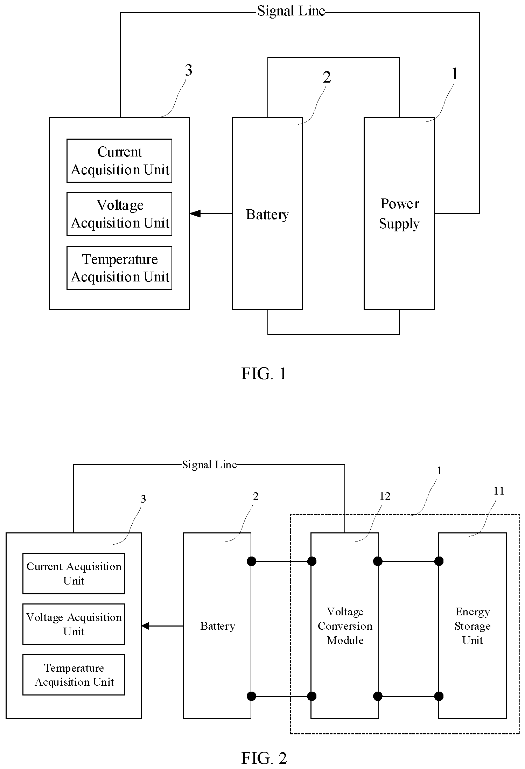

Generally, the power battery can be charged by using an alternating-current power supply or an energy storage battery. As an example, FIG. 1 and FIG. 2 are schematic diagrams of possible application scenarios of the embodiments of the present application. For example, in the heating system shown in FIG. 1, the heating circuit 1 may include a power supply, and the power supply is connected to the battery 2 and is configured to output a heating current to the battery 2. As another example, as shown in FIG. 2, the heating circuit 1 may include an energy storage unit 11 and a voltage conversion unit 12, where the voltage conversion module 12 is connected between the energy storage unit 11 and the battery 2, and the energy storage unit 11 is configured to output a heating current to the battery 2 through the voltage conversion module 12. The voltage converting module 12 may be, for example, a DC/DC.

In FIG. 1 and FIG. 2, the battery 2 is connected to a heating apparatus 3, the heating apparatus 3 may be, for example, a BMS or a control circuit of the heating circuit 1, and the heating apparatus 3 is configured to acquire state information of the battery 2, for example, the heating apparatus 3 may include a current acquisition unit, a pressure acquisition unit and a temperature acquisition unit, which respectively acquire information of the current, voltage and temperature of the battery 2, and this information can be used to determine the optimal frequency of the heating current for heating the battery 2, thereby improving the heating efficiency of the battery 2.

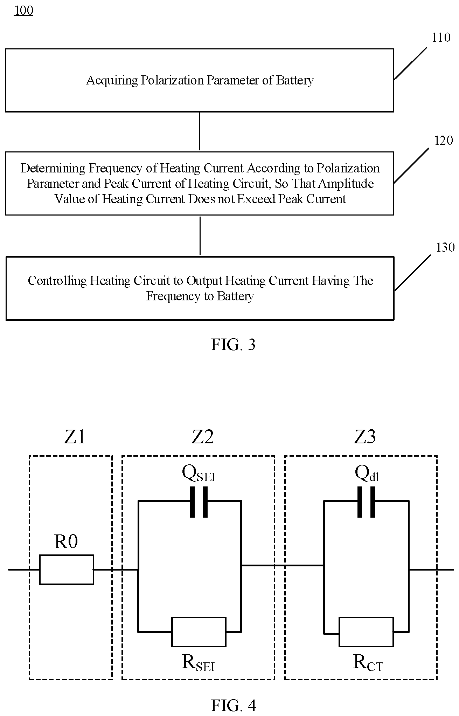

FIG. 3 is a schematic flow diagram of a battery heating method 100 according to the embodiments of the present application. The heating method 100 shown in FIG. 3 may be executed by the heating apparatus 3, for example, the heating apparatus 3 may be a BMS, and alternatively, the heating apparatus 3 may be a control circuit of the heating circuit 1. The heating method 100 is applied to the heating circuit 1, and the heating circuit 1 is connected to the battery 2 and is configured to outputting a heating current to the battery 2, the heating current being used for heating the battery 2.

As shown in FIG. 3, the heating method 100 includes some or all of the following steps:

step 110, acquiring polarization parameters of a battery 2, the polarization parameters including, for example, a polarization internal resistance and a polarization capacitance of the battery 2;
step 120, determining the frequency of the heating current according to the polarization parameters and the peak current of a heating circuit 1, so that the amplitude value of the heating current does not exceed the peak current; and step 130, controlling the heating circuit 1 to output the heating current having the frequency to the battery 2.

Here, the heating circuit 1 outputs an alternating-current heating current to the battery 2 so as to heat the battery 2. The frequency of the heating current is related to the heating efficiency, so it is necessary to determine an optimal frequency of the heating current. In the embodiments of the present application, during determination of the optimal frequency of the heating current, the peak current of the heating circuit 1 needs to be taken as a condition, so as to prevent the amplitude value of the heating current from exceeding the peak current of the heating circuit 1, thereby avoiding damage to other components in the heating circuit 1 in the heating process.

In the embodiments of the present application, in the process of heating the battery 2, the temperature and the SOC of the battery 2 change gradually, and the optimal frequency of the heating current also changes accordingly; therefore, the frequency of the heating current can be adjusted in the heating process. For example, when the temperature of the battery 2 is lower than T0, it is determined that the frequency of the heating current is $f1$ and heating of the battery 2 is started; when the temperature of the battery 2 is heated from T0 to T1, it is re-determined that the frequency of the heating current is $f2$ and the battery 2 is heated; when the temperature of the battery 2 is heated from T1 to T2, it is re-determined that the frequency of the heating current is $f3$ and the battery 2 is heated; ......, until the temperature of the battery 2 reaches the target value TX. In the heating process of the battery 2, the temperature of the battery is continuously increased, and thus T0 < T1< T2 < ...... <Tx, that is, in the heating process of the battery 2, the frequency of the heating current can be adjusted in real time, so as to optimize the heating performance.

In the embodiments of the present application, the heating current is an alternating current, and the waveform of the heating current is not limited, for example, the waveform of the alternating current may be any one of a pulse wave, a square wave, a triangular wave, and a sine wave.

In one implementation, in step 120, determining the frequency of the heating current according to the polarization parameters and the peak current of the heating circuit 1, so that the amplitude value of the heating current does not exceed the peak current includes: determining the frequency of the heating current according to the polarization parameters, the peak current and an equilibrium potential of a lithium plating reaction of the battery 2, so that the amplitude value of the heating current does not exceed the peak current and a polarization voltage of the battery 2 does not exceed the equilibrium potential.

That is, taking the peak current of the heating circuit 1 and the equilibrium potential of the lithium plating reaction as a condition during the determination of the optimal frequency of the heating current not only can prevent the amplitude value of the heating current from exceeding the peak current of the heating circuit 1, but also avoid damage to other components in the heating circuit 1, and can avoid a lithium plating phenomenon caused by the fact that the polarization voltage of the battery 2 exceeds the equilibrium potential of the lithium plating reaction, thereby ensuring the safety of the battery 2.

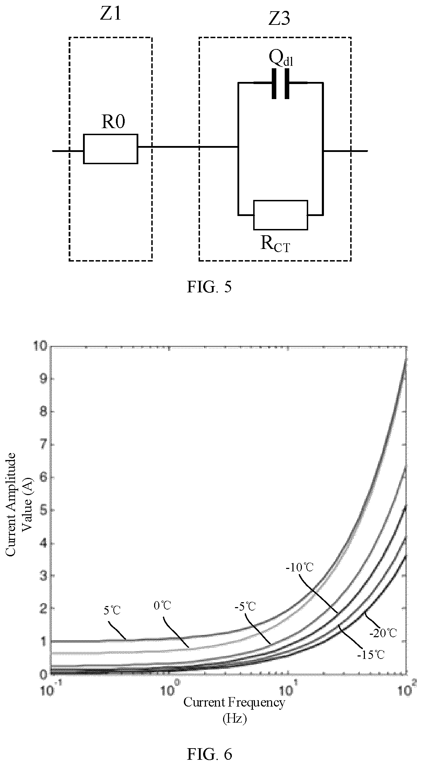

In order to better explain the heating solution of the present application, the condition for preventing lithium plating of the battery 2 is described first with reference to the equivalent circuit shown in FIG. 4 and FIG. 5.

The equivalent circuit in FIG. 4 is composed of three portions, i.e. Z1, Z2, and Z3, where Z1 includes ohmic impedance components of a current collector, an active substance, an electrolyte, etc. inside the battery 2; Z2 includes an impedance component corresponding to an SEI film on a particle surface; and Z3 includes the electric double layer capacitance Qdl at the solid-liquid phase interface of the active substance, the charge transfer impedance $R_{CT}$, and the impedance W corresponding to the diffusion process of lithium ions.

In charging of the battery 2, lithium ions are deintercalated from the positive electrode and are intercalated into the negative electrode. However, when some abnormal conditions occur and as a result, the lithium ions deintercalated from the positive electrode cannot be intercalated into the negative electrode, the lithium ions can only be precipitated on the surface of the negative electrode to form a layer of gray substance, and this phenomenon is called lithium plating, which is a loss condition for lithium ion batteries.

The lithium plating reaction of the battery 2 mainly occurs in the portion Z3, and therefore the portion Z2 can be omitted to form an equivalent circuit as shown in FIG. 5. In order to avoid lithium plating of the battery 2, a solid-liquid phase potential difference of the particle surface of the negative electrode needs to be greater than an equilibrium potential of the lithium plating reaction, that is:

$$\phi_s - \phi_l > U_{e,2} \tag{1};$$

$\varphi_s$ and $\varphi_l$ are the negative electrode potential and the lithium plating potential, respectively, of the battery 2, $U_{e,2}$ is the equilibrium potential of the lithium plating reaction of the battery 2, and generally, $U_{e,2}$ can be considered as 0V, i.e. a ground potential.

When the lithium plating reaction occurs, the lithium ions need to be restored to lithium metal by obtaining electrons, and it is generally considered that the lithium plating reaction initially occurs inside an SEI film on the surface of graphite particles, and the overpotential of a lithium intercalating reaction here is:

$$\eta = \phi_s - \phi_l - U_{e,1} \tag{2};$$

$U_{e,1}$ is the equilibrium potential of the graphite anode at a particular SOC.

According to the derivation process of the impedance spectrum of the battery 2, by the linearization of a Butler-Volmer equation, the overpotential can be approximated as:

$$\eta = i_{ct} R_{ct} \qquad (3);$$

$i_{ct}$ is the Faradic current, $R_{ct}$ is the charge transfer impedance, and when the battery 2 is charged, $i_{ct}$ is negative.

Referring to the equivalent circuit of the graphite anode shown in FIG. 5, it is obtained that:

$$i_{ct} R_{ct} = -V3 \qquad (4);$$

V3 is the voltage across the charge transfer impedance $R_{CT}$, i.e., the voltage across the portion Z3.

Based on the formulas (2) to (4), it can be obtained that the condition needing to be satisfied for preventing the occurrence of lithium plating of the battery 2 is:

$$V3 < U_{e,1} \qquad (5);$$

the impedance of the portion Z3 is related to the frequency of the current, and the expression thereof is:

$$Z_3 = \frac{R_{ct}}{(j\omega)^{n_{dl}} Q_{dl} R_{ct} + 1} \qquad (6);$$

$Q_{dl}$ is a constant phase element (CPE), and the constant phase element is described by a CPE coefficient Q and a CPE indication n, and the impedance thereof is:

$$Z_{CPE} = \frac{1}{(j\omega)^n} = \frac{1}{\left( \cos\dfrac{n\pi}{2} + j\sin\dfrac{n\pi}{2} \right) \omega^n Q} \qquad (7);$$

when the battery 2 is excited by an alternating current, the voltage amplitude value across the portion Z3 is:

$$\left| V_3 \right| = I_{ac} \left| Z_3 \right| \qquad (8);$$

IZ31 is the impedance amplitude value of the portion Z3 of the equivalent circuit, which is related to the frequency, and Iac is the amplitude value of the applied alternating current.

It can be obtained from formula (5) and formula (8) that, under the excitation of the alternating current, the condition for preventing the occurrence of lithium plating of the battery 2 is:

$$I_{ac} \left| Z_3 \right| < U_{e,1} \qquad (9);$$

that is, in the equivalent circuit of the graphite anode of the battery 2, the voltage amplitude value across the portion Z3, or the voltage amplitude value across the charge transfer impedance $R_{CT}$ is always smaller than the equilibrium potential of the graphite anode.

Based on the above analysis, in order to improve the heating efficiency of the battery 2 and ensure the safety of the battery 2, the heating current I and the internal resistance of the battery 2 need to be as large as possible, and further need to satisfy the condition of the equation (9).

According to the formula (6) and the formula (9), the relationship between the maximum allowable amplitude value of the heating current and the frequency at different temperatures under the condition of suppressing lithium plating as shown in FIG. 6 can be obtained. It can be determined that the impedance amplitude value of the portion Z3 in the equivalent circuit decreases with the increase of the frequency, and therefore under the condition of suppressing lithium plating, the maximum allowable amplitude value of the current increases with the increase of the frequency.

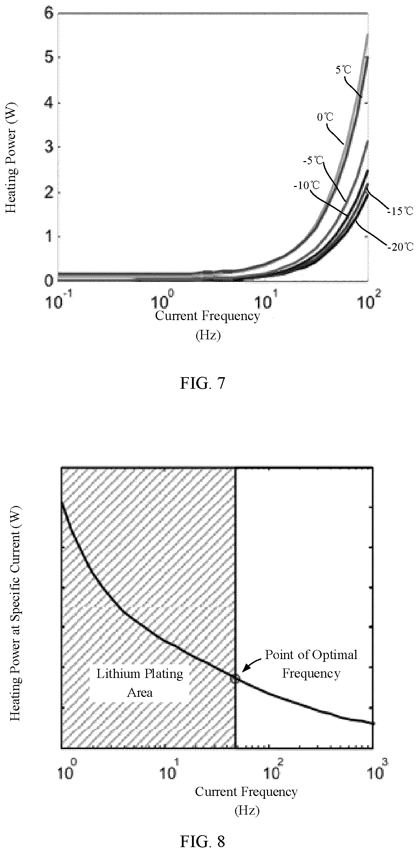

FIG. 7 shows the influence of the temperature and frequency on a heating power under the condition of suppressing lithium plating. The heating power P of the battery 2 is related to the heating current I and the internal resistance R of the battery, i.e. $P = I^2R$, and the larger the heating current I and the internal resistance R are, the larger the heating power P is. In FIG. 5, as the frequency increases and the current component passing through the $R_{CT}$ and $R_{SEI}$ decreases, the heating power P may be more from the ohmic internal resistance R0. In cases where the amplitude value of the current is not limited, by increasing the frequency, the current component passing through the polarization inner resistance $R_{CT}$ can be decreased, and the polarization voltage decreases, so as to avoid lithium plating of the battery 2, and furthermore, as the amplitude value of the current is increased, more heat can be generated by means of the ohmic inner resistance R0.

However, actually, as devices such as a wire harness and a switch exist in a heating system, the devices in a system loop have a limitation of a maximum withstand current, that is, the heating system has a limitation of a peak current $I_A$; given a maximum current amplitude value, when the frequency is too low, the current component passing through the polarization internal resistance $R_{CT}$ increases, and the polarization voltage increases, so that the potential of the negative electrode of the battery decreases, which may cause lithium plating; and when the frequency is too high, the overall impedance of the battery decreases, so that the heating power decreases. In this case, an optimal frequency needs to be chosen in order to ensure that the amplitude value of the heating current does not exceed the peak current $I_A$ and to avoid lithium plating of the battery 2.

FIG. 8 shows the most preferred choice of the frequency of the heating current when the amplitude value of the heating current is limited, where the shaded portion is a lithium plating area, and at a right boundary of the shaded portion, the maximum heating power when lithium plating of the battery 2 does not occur can be obtained, and the corresponding frequency at this position is the optimal frequency.

For example, when the pulse waveform of the heating current is a square wave, in a temperature rise rate test of a 67AH battery under a 2C current, the amplitude value of the heating current is fixedly set to be 134 A, and when the frequency $f$ of the heating current is 1 Hz, 5 Hz and 10 Hz respectively, the temperature rise rate is 6°C/min, 2.8°C/min and 2.3°C/min respectively.

It can be determined that lowering the frequency $f$ under the same current helps to increase the temperature rise rate. But it should be noted that when the frequency $f$ is too low, there may be a risk of lithium plating.

In order to facilitate analysis of the equivalent circuit of the battery 2, in one implementation, in step 120, determining the frequency of the heating current according to the polarization parameters, the peak current, and an equilibrium potential of a lithium plating reaction of the battery 2 includes: determining, according to the polarization internal resistance, the polarization capacitance, the peak current and the equilibrium potential, the angular frequency of the heating current; and determining the frequency of the heating current according to the angular frequency of the heating current.

For example, the angular frequency $\omega$ of the heating current, i.e. the circular frequency $\omega$ of the alternating current for heating, may be determined according to the polarization internal resistance and polarization capacitance of the battery 2, and the peak current of the heating circuit 1 and the equilibrium potential of the lithium plating reaction, and then the frequency $f$ of the heating current is determined according to $\omega = 2\pi f$; and the calculation is simple and easy to implement.

In one implementation, in step 120, determining the angular frequency of the heating current according to the polarization internal resistance, the polarization capacitance, the peak current and the equilibrium potential includes: determining, according to the polarization internal resistance, the polarization capacitance, the peak current and the equilibrium potential, the angular frequency of the heating current based on the following formula:

$$[R1/(1+j\omega R1C1)]\times I_A = X \times U_{e,1} \qquad\qquad (10);$$

R1 is the polarization internal resistance of the battery 2, C1 is the polarization capacitance of the battery 2, $I_A$ is the peak current of the heating circuit 1, $U_{e,1}$ is the corresponding equilibrium potential of the battery 2 at the current SOC, $\omega$ is the angular frequency of the heating current, X is a preset value, and X is greater than 0 and less than or equal to 1, i.e. $0 < X \leq 1$.

When the polarization internal resistance R1 and the polarization capacitance C1 of the battery 2 are acquired in advance, according to the formula (10), i.e. $[R1/(1+j\omega R1C1)]\times I_A = X \times U_{e,1}$, an optimal angular frequency $\omega$ of the heating current can be obtained, and the optimal frequency $f$ of the heating current can be further obtained.

The polarization voltage of the battery 2 $U_x = [R1/(1+j\omega R1C1)]\times I$, where by setting the parameter X to satisfy

$0<X\leq1$, and enabling that $Ux=X\times U_{e,1}$, the polarization voltage Ux can be enabled not to exceed the equilibrium potential $U_{e,1}$, thereby avoiding the phenomenon of lithium plating caused by the fact that the polarization voltage Ux of the battery 2 exceeds the equilibrium potential $U_{e,1}$ of the lithium plating reaction. In addition, the current I in $Ux=[R1/(1+j\omega R1C1)]\times I$ is limited to be equal to the peak current $I_A$ of the heating circuit 1, so as to prevent the amplitude value of the heating current from exceeding the peak current $I_A$ of the heating circuit 1, thereby avoiding damage to other elements in the heating circuit 1 in the heating process.

In order to acquire the polarization internal resistance R1 and the polarization capacitance C1 of the battery 2, in one implementation, in step 110, acquiring the polarization parameters of the battery 2 includes: determining, according to the equivalent circuit of the battery 2, an equation representing a relationship among an open circuit voltage, a terminal voltage, and a current of the battery 2, the equation being associated with the polarization internal resistance and the polarization capacitance; performing sampling on the open circuit voltage, the terminal voltage and the current in the heating process for multiple times, so as to obtain a plurality of sets of sampling data; and according to the plurality of sets of sampling data, determining the polarization internal resistance and the polarization capacitance based on the equation.

By establishing the equivalent circuit of the battery 2, the equation representing the relationship among the open circuit voltage, the terminal voltage and the current of the battery 2 is obtained, the equation being associated with the polarization internal resistance and the polarization capacitance of the battery 2. In this way, by sampling the open circuit voltage, the terminal voltage and the current of the battery 2 in the heating process for multiple times in advance, the plurality of sets of sampling data can be obtained, and by substituting the plurality of sets of sampling data into the equation, the polarization internal resistance and the polarization capacitance of the battery 2 can be obtained; and the calculation is simple and easy to implement. Therefore, in cases where the polarization internal resistance and the polarization capacitance of the battery 2 are obtained in advance, the angular frequency of the heating current can be obtained according to the above formula (10), i.e. $[R1/(1+j\omega R1C1)]\times I_A=X\times U_{e,1}$, and the frequency of the heating current may be further obtained.

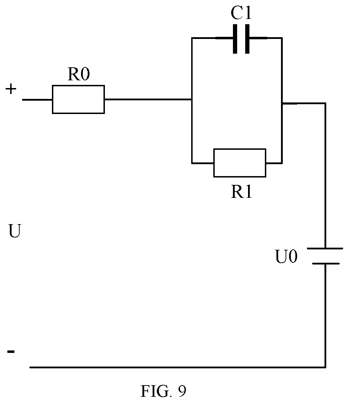

By taking FIG. 9 as an example, how to obtain the polarization internal resistance R1 and the polarization capacitance C1 of the battery 2 is described in detail.

FIG. 9 shows a first-order Thevenin equivalent circuit of the battery 2, and based on the equivalent circuit, a corresponding equation is established, so as to determine the polarization internal resistance R1 and the polarization capacitance C1. It should be understood that: here, the polarization internal resistance and the polarization capacitance of the battery are determined by establishing a first-order Thevenin equivalent circuit and a corresponding model formula thereof, and the model is simple and easy to implement. Certainly, in the embodiments of the present application, another circuit model may also be used to determine the polarization internal resistance and the polarization capacitance of the battery.

In FIG. 9, R0 is the ohm internal resistance of the battery 2, R1 is the polarization internal resistance, C1 is the polarization voltage, U0 is the open circuit voltage of the battery 2, and U is the terminal voltage of the battery 2. It should be understood that the ohmic internal resistance R0 may correspond to the ohmic internal resistance of the portion Z1 shown in FIG. 5, the polarization internal resistance R1 may correspond to the charge transfer impedance $R_{CT}$ of the portion Z3 shown in FIG. 5, and the polarization voltage C1 may correspond to the capacitance $Q_{dl}$ of the portion Z3 shown in FIG. 5.

Based on the equivalent circuit shown in FIG. 9, the following equation is obtained:

$$U0=[R1/(1+j\omega R1C1)]\times I_A+I\times R0+U \qquad\qquad (11),$$

where

U0 is the corresponding open circuit voltage of the battery 2 at the current SOC and temperature, U is the terminal voltage, I is the current, R1 is the polarization internal resistance, C1 is the polarization capacitance, $\omega$ is the angular frequency of the heating current, and R0 is the ohmic internal resistance of the battery 2.

Formula (11) describes the relationship among the open circuit voltage $U_0$, the terminal voltage U, and the current I of the battery 2, and is associated with the polarization internal resistance R1 and the polarization capacitance C1 of the battery 2. Therefore, by performing sampling on the open circuit voltage $U_0$, the terminal voltage U and the current I of the battery 2 for multiple times in the heating process, the plurality of sets of sampling data can be obtained, and by substituting the plurality of sets of sampling data into the equation, the polarization internal resistance R1 and the polarization capacitance C1 of the battery 2 and the ohmic internal resistance R0 of the battery 2 can be obtained.

In one implementation, determining, according to the plurality of sets of sampling data, the polarization internal resistance R1 and the polarization capacitance C1 based on the equation includes:

first, converting equation (10) into a polynomial in a differential form, for example, enabling that $s = (x(k)-x(k-1))/T$, where T is a sampling time interval, x represents sampling parameters such as the open circuit voltage $U_0$, the terminal voltage U and the current I, and the obtained differential polynomial is:

$$U_0(k)-U(k)=k1\times[U_0(k-1)-U(k-1)]+k2\times I(k)-k3\times I(k-1) \tag{12},$$

where

$$k1=R1C1/(T+R1C1) \tag{13};$$

$$k2=[R0R1C1+T(R0+R1)]/(T+R1C1) \tag{14};$$

and

$$k3=R0R1C1/(T+R1C1) \tag{15},$$

where

$U_0(k)$ and $U_0(k-1)$ are the sampling data of the open circuit voltage obtained by performing kth sampling and performing (k-1)th sampling respectively, U(k) and U(k-1) are the sampling data of the terminal voltage obtained by performing the kth sampling and performing the (k-1)th sampling respectively, I(k) and I(k-1) are the sampling data of the current obtained by performing the kth sampling and performing the (k-1)th sampling respectively, and k is a positive integer greater than 1;
second, according to the plurality of sets of sampling data, determining k1, k2 and k3 based on the polynomial (12); and finally, determining the polarization internal resistance R1 and the polarization voltage C1 according to k1, k2, and k3.

As the three parameters k1, k2 and k3 are solved by using the differential polynomial, the total number of sampling is usually not less than 4.

That is, the open circuit voltage $U_0$, the terminal voltage U and the current I are sampled for multiple times to obtain the plurality of sets of sampling data of the open circuit voltage $U_0$, the terminal voltage U and the current I, for example, $U_0$(k), $U_0$(k-1), U(k), U(k-1), I(k) and I(k-1). The plurality of sets of sampling data are respectively substituted into formula (12) to obtain a plurality of equations associated with the ohmic internal resistance R0, the polarization internal resistance R1 and the polarization capacitance C1 of the battery 2, so as to solve k1, k2 and k3. Finally, according to k1, k2, and k3, and formulas (13) to (15), the ohmic internal resistance R0, the polarization internal resistance R1, and the polarization capacitance C1 of the battery 2 can be obtained respectively:

$$R0=k3/k1 \tag{16};$$

$$R1=(k2-k3)/(1-k1)-k3/k1 \tag{17};$$

and

$$C1=(k1\times k1\times T)/[k1\times(k2-k3)-k3\times(1-k1)] \tag{18};$$

The sampling data of the open circuit voltage $U_0$ of the battery 2 can be determined, for example, by acquiring the SOC and the temperature, from the MAP table according to the SOC and the temperature. The MAP table shows the corresponding open circuit voltage $U_0$ of the battery 2 calibrated before delivery at different temperatures and different sacs. The sampling data of the terminal voltage U and the current I of the battery 2 can be obtained by detecting the voltage and the current.

It can be determined that, by converting the equation corresponding to the equivalent circuit of the battery 2 into the polynomial in a differential form, an imaginary part in the equation can be effectively removed, thereby facilitating the determination of the polarization internal resistance R1 and the polarization capacitance C1 of the battery 2 by using the sampling data of the open circuit voltage $U_0$, the terminal voltage U, and the current I.

In this way, in cases where the polarization internal resistance R1 and the polarization capacitance C1 of the battery 2 are obtained in advance, the angular frequency $\omega$ of the heating current can be obtained according to the above formula (10), i.e. $[R1/(1+j\omega R1C1)]\times I_A=X\times U_{e,1}$, and the frequency $f$ of the heating current can be further obtained according to $\omega=2\pi f$.

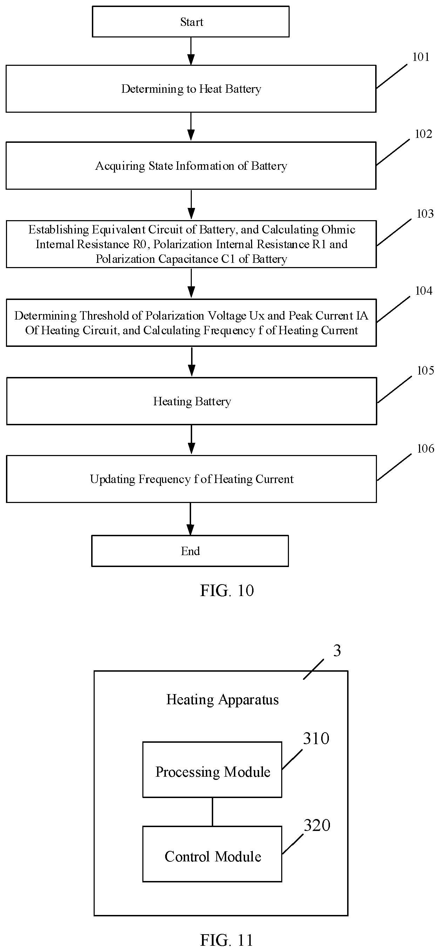

FIG. 10 shows a flow diagram of a possible specific implementation based on the heating method 100 shown in FIG. 3, where

in step 101, it is determined to heat the battery 2,

for example, upon receiving a battery heating request, it is determined to heat the battery 2, the battery heating request being used for instructing to heat the battery 2, and

for another example, when the temperature of the battery 2 is lower than a preset temperature T0, it is determined to heat the battery 2;

in step 102, state information of the battery 2 is acquired,

the state information including, for example, information such as the current temperature, SOC, voltage, and current of the battery 2;

in step 103, an equivalent circuit of the battery 2 is established, and an ohmic internal resistance R0, a polarization internal resistance R1 and a polarization capacitance C1 of the battery 2 are calculated;

here, the equivalent circuit of the battery 2 is established, the open circuit voltage U0, the terminal voltage U and the current I of the battery 2 are sampled, and the ohmic internal resistance R0, the polarization internal resistance R1 and the polarization capacitance C1 of the battery 2 are calculated according to the sampling data, the open circuit voltage U0 being determined based on the SOC and the temperature;

in step 104, the threshold of the polarization voltage Ux and the peak current $I_A$ of the heating circuit 1 are determined, and the frequency $f$ of the heating current is calculated;

the polarization voltage $Ux=[R1/(1+j\omega R1C1)]\times I_A$, wherein X may be set to be located between 0 and 1, for example, may be set to be 0.9, so that Ux is less than the equilibrium potential $U_{e,1}$, the corresponding $U_{e,1}$ can be determined according to the current SOC of the battery 2,

and enabling that $[R1/(1+j\omega R1C1)\times I_A=X\times U_{e,1}$, in cases where the polarization inner resistance R1 and the polarization capacitance C1 are known, the angular frequency $\omega$ of the heating current is determined by taking the parameter X, the peak current $I_A$ and the equilibrium potential $U_{e,1}$ as limiting conditions, and the frequency $f$ of the heating current is determined according to $\omega=2\pi f$;

in step 105, the battery 2 is heated according to the frequency $f$ determined in step 104;

in step 106, it is determined to update the frequency $f$ of the heating current,

for example, when the battery heating request is received again, it is determined to re-execute steps 102 to 105, so as to update the frequency $f$ of the heating current, and

for another example, when the temperature of the battery 2 is lower than the preset temperature T1, and T1>T0, it is determined to re-execute steps 102 to 105, so as to update the frequency $f$ of the heating current.

The flow shown in FIG. 10 is executed until the temperature of the battery 2 reaches the required temperature threshold Tx.

In the flow shown in FIG. 10, when the battery 2 is heated, real-time sampling can be performed and the polarization internal resistance R1 and the polarization capacitance C1 of the battery 2 at different SOCs and temperatures can be calculated, so that the frequency $f$ of the heating current is determined by taking the parameter X, the peak current $I_A$ and the equilibrium potential $U_{e,1}$ as limiting conditions.

However, in order to further improve the heating efficiency, the polarization internal resistance R1 and the polarization capacitance C1 of the battery 2 at different SOCs and temperatures can be calculated in advance and stored. In this way, when the battery 2 is heated, the calculated polarization internal resistance R1 and the polarization capacitance C1 can be directly read and used, and it is unnecessary to perform sampling in real time and calculate the polarization internal resistance R1 and the polarization capacitance C1 of the battery 2 at different SOCs and temperatures for every heating.

It should also be understood that, in the embodiments of the present application, the maximum amplitude value of the heating current is limited to be the peak current $I_A$ of the heating circuit 1, and in practical applications, the maximum amplitude value of the heating current may also be limited to be slightly less than the peak current $I_A$.

By means of the heating method in the embodiments of the present application, the battery 2 can be effectively heated, and the amplitude value of the heating current is prevented from exceeding the peak current of the heating circuit 1, thereby avoiding damage to other components in the heating circuit 1 in the heating process. Furthermore, a lithium plating phenomenon, caused by the fact that the polarization voltage of the battery 2 exceeds the equilibrium potential of the lithium plating reaction, can be avoided, thereby ensuring the safety of the battery 2.

FIG. 11 shows a heating apparatus 3 of the battery 2 according to the embodiments of the present application. The heating apparatus 3 is applied to the heating circuit 1, the heating circuit 1 is connected to the battery 2 and is configured to output a heating current to the battery 2, and the heating current is configured to heat the battery 2. The heating apparatus 3 includes:

a processing module 310, configured to acquire polarization parameters of the battery 2, and determine a frequency of the heating current according to the polarization parameters and a peak current of the heating circuit 1, so that the amplitude value of the heating current does not exceed the peak current; and

a control module 320, configured to control the heating circuit 1 to output a heating current having the frequency to the battery 2.

In one implementation, the processing module 310 is specifically configured to: determine, according to the polarization parameters, the peak current and the equilibrium potential of the lithium plating reaction of the battery 2, the frequency of the heating current, so that the amplitude value of the heating current does not exceed the peak current, and the polarization voltage of the battery 2 does not exceed the equilibrium potential.

In one implementation, the polarization parameters include the polarization internal resistance and the polarization capacitance of the battery 2.

In one implementation, the processing module 310 is specifically configured to: determine an angular frequency of the heating current according to the polarization internal resistance, the polarization capacitance, the peak current and the equilibrium potential; and determine the frequency of the heating current according to the angular frequency of the heating current.

In one implementation, the processing module 310 is specifically configured to: determine the angular frequency of the heating current according to the polarization internal resistance, the polarization capacitance, the peak current and the equilibrium potential based on the following formula:

$$[R1/(1+j\omega R1C1)] \times I_A = X \times U_{e,1},$$

where R1 is the polarization internal resistance, C1 is the polarization capacitance, $I_A$ is the peak current, $U_{e,1}$ is the corresponding equilibrium potential of the battery 2 at the current state of charge (SOC), $\omega$ is the angular frequency of the heating current, X is a preset value, and X is greater than 0 and less than or equal to 1.

In one implementation, the processing module 310 is specifically configured to: determine the frequency of the heating current according to $\omega = 2\pi f$, where $\omega$ is the angular frequency of the heating current, and $f$ is the frequency of the heating current.

In one implementation, the processing module 310 is specifically configured to: determine, according to the equivalent circuit of the battery 2, an equation for representing a relationship among the open circuit voltage, the terminal voltage and the current of the battery 2, where the equation is associated with the polarization internal resistance and the polarization capacitance; perform sampling on the open circuit voltage, the terminal voltage and the current in a heating process for multiple times to obtain a plurality of sets of sampling data; and according to the plurality of sets of sampling data, determine the polarization internal resistance and the polarization capacitance based on the equation.

In one implementation, the equivalent circuit is a first-order Thevenin equivalent circuit, and the equation is: $U0 = [R1/(1+j\omega R1C1)] \times I_A + I \times R0 + U$, where $U_0$ is the corresponding open circuit voltage of the battery 2 at the current SOC and temperature, U is the terminal voltage, I is the current, R1 is the polarization internal resistance, and C1 is the polarization capacitance.

In one implementation, the processing module 310 is specifically configured to: convert the equation to a polynomial in a differential form: $U_0(k) - U(k) = k1 \times [U_0(k-1) - U(k-1)] + k2 \times I(k) - k3 \times I(k-1)$, where k1=R1C1/(T+R1C1), k2=[R0R1C1+T(R0+R1)]/(T+R1C1), k3=R0R1C1/(T+R1C1), $U_0(k)$ and $U_0(k-1)$ are the sampling data of the open circuit voltage obtained by performing kth sampling and performing (k-1)th sampling respectively, U(k) and U(k-1) are the sampling data of the terminal voltage obtained by performing the kth sampling and performing the (k-1)th sampling respectively, I(k) and I(k-1) are the sampling data of the current obtained by performing the kth sampling and performing the (k-1)th sampling respectively, T is a sampling time interval, and k is a positive integer greater than 1; according to the plurality of sets of sampling data, determine k1, k2 and k3 based on the polynomial; and according to k1, k2 and k3, determine that the polarization internal resistance and the polarization voltage are R1=(k2-k3)/(1-k1)-k3/k1 and C1=(k1×k1×T)/[k1×(k2-k3)-k3×(1-k1)], respectively.

In one implementation, the heating current is an alternating current, and the waveform of the alternating current is any one of a pulse wave, a square wave, a triangular wave, and a sine wave.

In one implementation, the heating circuit 1 includes a power supply, and the power supply is connected to the battery.

In one implementation, the heating circuit 1 includes an energy storage unit and a voltage conversion module, and the voltage conversion module is connected between the energy storage unit and the battery 2.

In one implementation, the heating apparatus 3 is a control circuit of the heating circuit 1, or the heating apparatus 3 is a BMS of the battery.

The present application further provides a battery heating apparatus, including a memory and a processor, where the memory is configured to store a computer program, the processor is configured to invoke and run the computer program stored in the memory, so as to execute the battery heating method in any one of the described embodiments.

The present application further provides a computer-readable storage medium, which is configured to store a computer program, where the computer program causes a computer to execute the battery heating method in any one of the described embodiments.

The present application further provides a battery heating system, including: a battery; a heating circuit connected to the battery; and a battery heating apparatus in any one of the described embodiments, connected to the heating circuit and configured to control the heating circuit to output a heating current, the heating current being configured to heat the battery.

The present application further provides a power device, including a battery, a heating circuit, and a heating apparatus in any one of the described embodiments, the heating apparatus being connected to the heating circuit, and being configured to control the heating circuit to output a heating current, the heating current being configured to heat the battery. The power device may be, for example, a power vehicle or the like.

Those of ordinary skill in the art may be aware that, in combination with units and algorithm steps in the examples described in the embodiments disclosed herein, the disclosed system, apparatus, and method may be implemented by means of electronic hardware, or a combination of computer software and electronic hardware. Whether these functions are executed by hardware or software depends on specific applications and design constraint conditions of the technical solutions. Those skilled in the art may use different methods to implement the described functions for each specific application, but this implementation shall not be considered as going beyond the scope of the present application.

It may be clearly understood by those skilled in the art that for the detailed working process of the described system, apparatus and units, reference may be made to the corresponding process in the described method embodiments, and details are omitted herein for the purpose of convenient and brief description.

In the several embodiments provided in the present application, it should be understood that the disclosed system, apparatus, and method may be implemented in other manners. For example, the apparatus embodiments described above are merely exemplary, for instance, the division of the units is merely a logical function division, and there may be other division manners in actual implementation, for example, a plurality of units or components may be combined or integrated into another system, or some features may be ignored or not executed. In addition, the displayed or discussed mutual couplings or direct couplings or communication connections may be implemented by means of some interfaces, and the indirect couplings or communication connections of devices or units may be implemented in electronic, mechanical, or other forms.

The units described as separate parts may or may not be physically separate, and parts displayed as units may or may not be physical units, i.e. may be located in one position, or may be distributed on a plurality of network units. Some or all of the units may be selected according to actual requirements to achieve the object of the solutions of the embodiments.

**Claims**

1. A battery heating method, applied to a heating circuit, wherein the heating circuit is connected to a battery and is configured to output a heating current to the battery, and the heating current is configured to heat the battery, the heating method comprising:

   acquiring polarization parameters of the battery;
   determining a frequency of the heating current according to the polarization parameters and a peak current of the heating circuit, so that an amplitude value of the heating current does not exceed the peak current; and
   controlling the heating circuit to output the heating current having the frequency to the battery.

2. The heating method according to claim 1, wherein determining a frequency of the heating current according to the polarization parameters and a peak current of the heating circuit, so that an amplitude value of the heating current does not exceed the peak current comprises:
   determining the frequency of the heating current according to the polarization parameters, the peak current, and an equilibrium potential of a lithium plating reaction of the battery, so that the amplitude value of the heating current does not exceed the peak current and a polarization voltage of the battery does not exceed the equilibrium potential.

3. The heating method according to claim 2, wherein the polarization parameters comprise a polarization internal resistance and a polarization capacitance of the battery.

4. The heating method according to claim 3, wherein determining the frequency of the heating current according to the polarization parameters, the peak current, and an equilibrium potential of a lithium plating reaction of the battery comprises:

> determining an angular frequency of the heating current according to the polarization internal resistance, the polarization capacitance, the peak current and the equilibrium potential; and
> determining the frequency of the heating current according to the angular frequency of the heating current.

5. The heating method according to claim 4, wherein determining an angular frequency of the heating current according to the polarization internal resistance, the polarization capacitance, the peak current, and the equilibrium potential comprises:
determining, according to the polarization internal resistance, the polarization capacitance, the peak current, and the equilibrium potential, the angular frequency of the heating current based on the following formula:

$$[R1/(1+j\omega R1C1)]\times I_A = X \times U_{e,1},$$

wherein R1 is the polarization internal resistance, C1 is the polarization capacitance, $I_A$ is the peak current, $U_{e,1}$ is the corresponding equilibrium potential of the battery in the current state of charge (SOC), $\omega$ is the angular frequency of the heating current, X is a preset value, and X is greater than 0 and less than or equal to 1.

6. The heating method according to claim 4 or 5, wherein determining the frequency of the heating current according to the angular frequency comprises:
determining the frequency of the heating current according to $\omega = 2\pi f$, wherein $\omega$ is the angular frequency of the heating current and $f$ is the frequency of the heating current.

7. The heating method according to any one of claims 3 to 6, wherein the acquiring polarization parameters of the battery comprises:

> determining, according to an equivalent circuit of the battery, an equation representing a relationship among an open circuit voltage, a terminal voltage, and a current of the battery, the equation being associated with the polarization internal resistance and the polarization capacitance;
> performing sampling on the open circuit voltage, the terminal voltage and the current in the heating process for multiple times, so as to obtain a plurality of sets of sampling data; and
> determining the polarization internal resistance and the polarization capacitance based on the equation according to the plurality of sets of sampling data.

8. The heating method according to claim 7, wherein the equivalent circuit is a first-order Thevenin equivalent circuit, and the equation is:

$$U0=[R1/(1+j\omega R1C1)]\times I_A + I\times R0 + U,$$

wherein $U_0$ is the corresponding open circuit voltage of the battery at the current SOC and temperature, U is the terminal voltage, I is the current, R1 is the polarization internal resistance, C1 is the polarization capacitance, and R0 is an ohmic internal resistance of the battery.

9. The heating method according to claim 8, wherein determining the polarization internal resistance and the polarization capacitance based on the equation according to the plurality of sets of sampling data comprises:

> converting the equation to a polynomial in a differential form:

$$U_0(k)-U(k)=k1\times[U_0(k-1)-U(k-1)]+k2\times I(k)-k3\times I(k-1),$$

wherein
k1=R1C1/(T+R1C1), k2=[R0R1C1+T(R0+R1)]/(T+R1C1), and k3=R0R1C1/(T+R1C1), wherein $U_0(k)$ and $U_0(k-1)$ are the sampling data of the open circuit voltage obtained by performing kth sampling and performing (k-1)th sampling respectively, U(k) and U(k-1) are the sampling data of the terminal voltage obtained by performing the kth sampling and performing the (k-1)th sampling respectively, I(k) and I(k-1) are the sampling data of the current obtained by performing the kth sampling and performing the (k-1)th sampling respectively, T is a sampling interval, and k is a positive integer greater than 1;

according to the plurality of sets of sampling data, determining k1, k2 and k3 based on the polynomial; and according to k1, k2 and k3, determining that the polarization internal resistance and the polarization voltage are R1=(k2-k3)/(1-k1)-k3/k1 and C1=(k1×k1×T)/[k1×(k2-k3)-k3×(1-k1)], respectively.

10. The heating method according to any one of claims 1 to 9, wherein the heating current is an alternating current, and the waveform of the alternating current is any one of a pulse wave, a square wave, a triangular wave, and a sine wave.

11. The heating method according to any one of claims 1 to 10, wherein the heating circuit comprises a power supply, and the power supply is connected to the battery.

12. The heating method according to any one of claims 1 to 10, wherein the heating circuit comprises an energy storage unit and a voltage conversion module, and the voltage conversion module is connected between the energy storage unit and the battery.

13. A battery heating apparatus, applied to a heating circuit, wherein the heating circuit is connected to a battery and is configured to output a heating current to the battery, the heating current is configured to heat the battery, and the heating apparatus comprises:

   a processing module, configured to acquire polarization parameters of the battery, and determine a frequency of the heating current according to the polarization parameters and a peak current of the heating circuit, so that the amplitude value of the heating current does not exceed the peak current; and
   a control module, configured to control the heating circuit to output the heating current having the frequency to the battery.

14. The heating apparatus according to claim 13, wherein the processing module is specifically configured to: determine the frequency of the heating current according to the polarization parameters, the peak current, and an equilibrium potential of a lithium plating reaction of the battery, so that the amplitude value of the heating current does not exceed the peak current and a polarization voltage of the battery does not exceed the equilibrium potential.

15. The heating apparatus according to claim 14, wherein the polarization parameters comprise a polarization internal resistance and a polarization capacitance of the battery.

16. The heating apparatus according to claim 15, wherein the processing module is specifically configured to:

   determine an angular frequency of the heating current according to the polarization internal resistance, the polarization capacitance, the peak current, and the equilibrium potential; and
   determine the frequency of the heating current according to the angular frequency of the heating current.

17. The heating apparatus according to claim 16, wherein the processing module is specifically configured to: determine, according to the polarization internal resistance, the polarization capacitance, the peak current, and the equilibrium potential, the angular frequency of the heating current based on the following formula:

$$[R1/(1+j\omega R1C1)] \times I_A = X \times U_{e,1},$$

wherein R1 is the polarization internal resistance, C1 is the polarization capacitance, $I_A$ is the peak current, $U_{e,1}$ is the corresponding equilibrium potential of the battery in the current state of charge (SOC), $\omega$ is the angular frequency of the heating current, X is a preset value, and X is greater than 0 and less than or equal to 1.

18. The heating apparatus according to claim 16 or 17, wherein the processing module is specifically configured to: determine the frequency of the heating current according to $\omega=2\pi f$, wherein $\omega$ is the angular frequency of the heating current and $f$ is the frequency of the heating current.

19. The heating apparatus according to any one of claims 15 to 18, wherein the processing module is specifically configured to:

determine, according to an equivalent circuit of the battery, an equation representing a relationship among an open circuit voltage, a terminal voltage, and a current of the battery, the equation being associated with the polarization internal resistance and the polarization capacitance;

perform sampling on the open circuit voltage, the terminal voltage and the current in the heating process for multiple times, so as to obtain a plurality of sets of sampling data; and

determine the polarization internal resistance and the polarization capacitance based on the equation according to the plurality of sets of sampling data.

20. The heating apparatus according to claim 19, wherein the equivalent circuit is a first-order Thevenin equivalent circuit, and the equation is:

$$U0=[R1/(1+j\omega R1C1)]\times I_A+I\times R0+U,$$

wherein $U_0$ is the corresponding open circuit voltage of the battery at the current SOC and temperature, U is the terminal voltage, I is the current, R1 is the polarization internal resistance, C1 is the polarization capacitance, and R0 is an ohmic internal resistance of the battery.

21. The heating apparatus according to claim 20, wherein the processing module is specifically configured to:

convert the equation to a polynomial in a differential form:

$$U_0(k)-U(k)=k1\times[U_0(k-1)-U(k-1)]+k2\times I(k)-k3\times I(k-1),$$

wherein
k1=R1C1/(T+R1C1), k2=[R0R1C1+T(R0+R1)]/(T+R1C1) and k3=R0R1C1/(T+R1C1), wherein $U_0(k)$ and $U_0(k-1)$ are the sampling data of the open circuit voltage obtained by performing kth sampling and performing (k-1)th sampling respectively, U(k) and U(k-1) are the sampling data of the terminal voltage obtained by performing the kth sampling and performing the (k-1)th sampling respectively, I(k) and I(k-1) are the sampling data of the current obtained by performing the kth sampling and performing the (k-1)th sampling respectively, T is a sampling time interval, and k is a positive integer greater than 1;

according to the plurality of sets of sampling data, determine k1, k2 and k3 based on the polynomial; and

according to k1, k2 and k3, determine that the polarization internal resistance and the polarization voltage are R1=(k2-k3)/(1-k1)-k3/k1 and C1=(k1 $\times$k1$\times$T)/[k1$\times$(k2-k3)-k3$\times$(1-k1)], respectively.

22. The heating apparatus according to any one of claims 13 to 21, wherein the heating current is an alternating current, and the waveform of the alternating current is any one of a pulsed wave, a square wave, a triangular wave, and a sine wave.

23. The heating apparatus according to any one of claims 13 to 22, wherein the heating circuit comprises a power supply, and the power supply is connected to the battery.

24. The heating apparatus according to any one of claims 13 to 22, wherein the heating circuit comprises an energy storage unit and a voltage conversion module, and the voltage conversion module is connected between the energy storage unit and the battery.

25. The heating apparatus according to any one of claims 13 to 24, wherein the heating apparatus is a control circuit of the heating circuit, or the heating apparatus is a battery management system (BMS) of the battery.

26. A battery heating apparatus, comprising a memory and a processor, wherein the memory stores computer instructions, and the processor invokes the computer instructions to cause the heating apparatus to implement the battery heating method according to any one of claims 1 to 12.

27. A computer-readable storage medium, configured to store a computer program, wherein the computer program, when executed by a computing device, causes the computing device to implement the battery heating method according to any one of claims 1 to 12.

28. A battery heating system, comprising:

a battery;
a heating circuit connected to the battery; and
the heating apparatus according to any one of claims 13 to 25, wherein the heating apparatus is connected to the heating circuit, the heating apparatus is configured to control the heating circuit to output a heating current, and the heating current is configured to heat the battery.

Signal Line

3    2    1

Current
Acquisition Unit

Voltage
Acquisition Unit

Battery

Power
Supply

Temperature
Acquisition Unit

FIG. 1

Signal Line

3    2    12    1    11

Current Acquisition
Unit

Voltage Acquisition
Unit

Battery

Voltage
Conversion
Module

Energy
Storage
Unit

Temperature
Acquisition Unit

FIG. 2

100

110

Acquiring Polarization Parameter of Battery

120

Determining Frequency of Heating Current According to Polarization Parameter and Peak Current of Heating Circuit, So That Amplitude Value of Heating Current Does not Exceed Peak Current

130

Controlling Heating Circuit to Output Heating Current Having The Frequency to Battery

FIG. 3

Z1                          Z2                          Z3

$Q_{SEI}$                   $Q_{dl}$

R0

$R_{SEI}$                   $R_{CT}$

FIG. 4

FIG. 5

FIG. 6

FIG. 7

FIG. 8

FIG. 9

```
                    ┌─────────────────────────┐
                    │          Start          │
                    └─────────────────────────┘
                                 │
                                 ▼
      ┌──────────────────────────────────────────────────┐   ╱ 101
      │            Determining to Heat Battery            │
      └──────────────────────────────────────────────────┘
                                 │
                                 ▼
      ┌──────────────────────────────────────────────────┐   ╱ 102
      │        Acquiring State Information of Battery      │
      └──────────────────────────────────────────────────┘
                                 │
                                 ▼
      ┌──────────────────────────────────────────────────┐   ╱ 103
      │ Establishing Equivalent Circuit of Battery, and   │
      │ Calculating Ohmic Internal Resistance R0,         │
      │ Polarization Internal Resistance R1 and           │
      │ Polarization Capacitance C1 of Battery            │
      └──────────────────────────────────────────────────┘
                                 │
                                 ▼
      ┌──────────────────────────────────────────────────┐   ╱ 104
      │ Determining Threshold of Polarization Voltage Ux  │
      │ and Peak Current IA Of Heating Circuit, and       │
      │ Calculating Frequency f of Heating Current        │
      └──────────────────────────────────────────────────┘
                                 │
                                 ▼
      ┌──────────────────────────────────────────────────┐   ╱ 105
      │                 Heating Battery                   │
      └──────────────────────────────────────────────────┘
                                 │
                                 ▼
      ┌──────────────────────────────────────────────────┐   ╱ 106
      │        Updating Frequency f of Heating Current    │
      └──────────────────────────────────────────────────┘
                                 │
                                 ▼
                    ┌─────────────────────────┐
                    │           End           │
                    └─────────────────────────┘
```

FIG. 10

```
                                        3
      ┌───────────────────────────────────────────┐
      │            Heating Apparatus               │
      │                                            │
      │      ┌──────────────────────────┐  310     │
      │      │    Processing Module     │          │
      │      └──────────────────────────┘          │
      │                   │                        │
      │      ┌──────────────────────────┐  320     │
      │      │     Control Module       │          │
      │      └──────────────────────────┘          │
      │                                            │
      └───────────────────────────────────────────┘
```

FIG. 11

## INTERNATIONAL SEARCH REPORT

International application No.

**PCT/CN2022/090368**

**A. CLASSIFICATION OF SUBJECT MATTER**

H01M 10/615(2014.01)i

According to International Patent Classification (IPC) or to both national classification and IPC

**B. FIELDS SEARCHED**

Minimum documentation searched (classification system followed by classification symbols)

H01M

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: 电流, 频率, 电池, 加热, 极化, 内阻, 电容, 析锂, current, frequency, battery, heat, polarization, resistance, capacitance, lithium, evolution

**C. DOCUMENTS CONSIDERED TO BE RELEVANT**

| Category* | Citation of document, with indication, where appropriate, of the relevant passages | Relevant to claim No. |
|---|---|---|
| Y | CN 113733986 A (BYD CO., LTD.) 03 December 2021 (2021-12-03) description, paragraphs 32-45, and figures 1-15 | 1, 10-13, 22-28 |
| Y | CN 105510843 A (BEIJING SHEEN POWER TECHNOLOGY CO., LTD.) 20 April 2016 (2016-04-20) description, paragraphs 7-38 | 1, 10-13, 22-28 |
| A | CN 105680114 A (BEIJING SHEEN POWER TECHNOLOGY CO., LTD.) 15 June 2016 (2016-06-15) entire document | 1-28 |
| A | CN 112582710 A (SUNWODA ELECTRIC VEHICLE BATTERY CO., LTD.) 30 March 2021 (2021-03-30) description, paragraphs 7-38 | 1-28 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **18 December 2022** | **12 January 2023** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

EP 4 465 416 A1

**INTERNATIONAL SEARCH REPORT**
Information on patent family members

International application No.

**PCT/CN2022/090368**

| Patent document cited in search report | | | Publication date (day/month/year) | Patent family member(s) | | | Publication date (day/month/year) |
|---|---|---|---|---|---|---|---|
| CN | 113733986 | A | 03 December 2021 | None | | | |
| CN | 105510843 | A | 20 April 2016 | CN | 105510843 | B | 27 April 2018 |
| CN | 105680114 | A | 15 June 2016 | CN | 105680114 | B | 03 November 2017 |
| CN | 112582710 | A | 30 March 2021 | CN | 112582710 | B | 10 June 2022 |

Form PCT/ISA/210 (patent family annex) (January 2015)